# EUROPEAN PATENT APPLICATION

(11) **EP 4 776 502 A1**
(43) Date of publication of application: **15.07.2026**
(21) Application number: 25225193.9
(22) Date of filing: 18.12.2025
(51) Int. Cl.: H02M 7/487, H02M 7/483, H02M 7/00, H02M 1/44, H05K 7/14, H05K 7/20

(54) **SYSTEMS FOR EXTENSION BUSBAR FOR INVERTER FOR ELECTRIC VEHICLE**

(30) Priority: 09.01.2025 US 202519015011
(71) Applicant: BorgWarner, Inc., Auburn Hills, MI 48326 (US)
(72) Inventor: UGARE, Chetan, Nuremberg (DE); APELSMEIER, Andreas, Pollenfeld (DE); BERINDAN, Stefan, Oberasbach (DE); AKKALA, Naga Venkata Kishore, Nuremberg (DE)
(74) Representative: Office Freylinger

(57) **Abstract**

A multi-level inverter configured to convert DC power to AC power to drive a motor includes a first printed circuit board for a two-level inverter, a power module electrically connected to the first printed circuit board; one or more busbars, one or more extension capacitors electrically connected to the one or more busbars, and a second printed circuit board electrically connected to the power module and to the first printed circuit board, wherein the second printed circuit board includes: one or more extension switches electrically connected to the one or more busbars, and one or more extension controllers to control the one or more extension switches.

## Description

### TECHNICAL FIELD

Various embodiments of the present disclosure relate generally to systems for an extension busbar for an inverter, and, more particularly, to systems for an extension busbar for an extension capacitor for an extension board for a multi-level inverter for an electric vehicle.

### BACKGROUND

Inverters, such as those used to drive a motor in an electric vehicle, for example, are responsible for converting High Voltage Direct Current (HVDC) into Alternating Current (AC) to drive the motor. In some systems, two-level inverters have a simple structure and a relatively low cost of production. However, some two-level inverters may generate an output voltage including a high level of harmonics and a relatively low efficiency at a higher switching frequency. The present disclosure is directed to overcoming one or more of these above-referenced challenges.

### SUMMARY OF THE DISCLOSURE

In some aspects, the techniques described herein relate to a system including a multi-level inverter configured to convert DC power to AC power to drive a motor, wherein the multi-level inverter includes: a first printed circuit board for a two-level inverter; a power module electrically connected to the first printed circuit board; one or more busbars; one or more extension capacitors electrically connected to the one or more busbars; and a second printed circuit board electrically connected to the power module and to the first printed circuit board, wherein the second printed circuit board includes: one or more extension switches electrically connected to the one or more busbars, and one or more extension controllers to control the one or more extension switches.

In some aspects, the techniques described herein relate to a system, wherein: the one or more busbars are two-level busbars, and the one or more extension capacitors are on the second printed circuit board.

In some aspects, the techniques described herein relate to a system, further including: one or more two-level busbars; and one or more two-level capacitors electrically connected to the one or more two-level busbars, wherein the one or more busbars are three-level busbars, are on the one or more extension capacitors, and are connected to the one or more two-level busbars.

In some aspects, the techniques described herein relate to a system, wherein the one or more busbars are between the one or more two-level capacitors and the power module.

In some aspects, the techniques described herein relate to a system, wherein the one or more extension capacitors are between the one or more two-level busbars and the second printed circuit board.

In some aspects, the techniques described herein relate to a system, wherein the second printed circuit board is electrically connected to the power module through the one or more busbars and to the first printed circuit board through one or more board-to-board connectors.

In some aspects, the techniques described herein relate to a system, wherein the one or more busbars include: a positive busbar; a negative busbar; and a neutral busbar.

In some aspects, the techniques described herein relate to a system, wherein the negative busbar is between the positive busbar and the neutral busbar.

In some aspects, the techniques described herein relate to a system, wherein the neutral busbar is between the positive busbar and the negative busbar.

In some aspects, the techniques described herein relate to a system, wherein the positive busbar includes a first positive connector to two-level capacitors on a first side of the positive busbar, and a second positive connector to the power module on a second side of the positive busbar, wherein the first side of the positive busbar is opposite to the second side of the positive busbar; and wherein the negative busbar includes a first negative connector to the two-level capacitors on a first side of the negative busbar, and a second negative connector to the power module on a second side of the negative busbar, wherein the first side of the negative busbar is opposite to the second side of the negative busbar.

In some aspects, the techniques described herein relate to a system, wherein the neutral busbar includes a neutral connector to the second printed circuit board on a same side of the one or more extension capacitors as the power module.

In some aspects, the techniques described herein relate to a system, wherein the positive busbar includes a positive connector extending in a first direction, and the neutral busbar includes a neutral connector extending in a second direction opposite to the first direction.

In some aspects, the techniques described herein relate to a system, wherein the negative busbar includes a negative connector extending in the first direction, and the neutral connector is between the positive connector and the negative connector along a longitudinal axis of the neutral busbar.

In some aspects, the techniques described herein relate to a system, further including: a battery configured to supply the DC power to the multi-level inverter; and the motor configured to receive the AC power from the multi-level inverter to drive the motor, wherein the multi-level inverter, the battery, and the motor are provided as a vehicle.

In some aspects, the techniques described herein relate to a busbar assembly for a multi-level inverter; the busbar assembly including: a positive busbar including a first positive connector to one or more extension capacitors, a second positive connector to one or more two-level capacitors, and a third positive connector to one or more power modules; a negative busbar including a first negative connector to the one or more extension capacitors, a second negative connector to the one or more two-level capacitors, and a third negative connector to the one or more power modules; and a neutral busbar including a first neutral connector to the one or more extension capacitors, and a second neutral connector to a multi-level extension board.

In some aspects, the techniques described herein relate to a busbar assembly, wherein the positive busbar, the negative busbar, and the neutral busbar are in a stacked arrangement.

In some aspects, the techniques described herein relate to a busbar assembly, further including: a two-level busbar assembly connectable to the busbar assembly, wherein the second positive connector is connected to the one or more two-level capacitors through the two-level busbar assembly.

In some aspects, the techniques described herein relate to a busbar assembly, wherein the busbar assembly is configured to cover the one or more extension capacitors and the one or more two-level capacitors.

In some aspects, the techniques described herein relate to an extension assembly for a multi-level inverter; the extension assembly including: one or more extension capacitors; a multi-level extension board including one or more extension switches; a positive busbar including a first positive connector to the one or more extension capacitors, a second positive connector to one or more two-level capacitors, and a third positive connector to one or more power modules; a negative busbar including a first negative connector to the one or more extension capacitors, a second negative connector to the one or more two-level capacitors, and a third negative connector to the one or more power modules; and a neutral busbar including a first neutral connector to the one or more extension capacitors, and a second neutral connector to the multi-level extension board.

In some aspects, the techniques described herein relate to an extension assembly, wherein the one or more two-level capacitors are connected to the one or more power modules through the positive busbar and the negative busbar.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a combined inverter and converter, according to one or more embodiments.
FIG. 2 depicts an exemplary system infrastructure for the combined inverter and converter of FIG. 1, according to one or more embodiments.
FIG. 3 depicts an exemplary electrical schematic of a T-Type three-level inverter, according to one or more embodiments.
FIG. 4 depicts a three-level extension printed circuit board, according to one or more embodiments.
FIG. 5 depicts a single side cooling system including an extension PCB located above a main PCB, according to one or more embodiments.
FIG. 6 depicts a single side cooling system including an extension PCB located below a main PCB, according to one or more embodiments.
FIG. 7 depicts a double side cooling system with an extension PCB including components on one side, according to one or more embodiments.
FIG. 8 depicts a double side cooling system with an extension PCB including components on two sides, according to one or more embodiments.
FIG. 9 depicts an exemplary system with capacitors on an extension board, according to one or more embodiments.
FIG. 10 depicts capacitors on an extension board, according to one or more embodiments.
FIG. 11 depicts a system including an extension assembly, according to one or more embodiments.
FIG. 12 depicts a connection of an extension assembly, according to one or more embodiments.
FIG. 13 depicts an extension capacitor and busbar assembly, according to one or more embodiments.
FIG. 14A depicts busbar connections in a first configuration, according to one or more embodiments.
FIG. 14B depicts busbar connections in a second configuration, according to one or more embodiments.
FIG. 14C depicts busbar connections in a third configuration, according to one or more embodiments.
FIG. 15 depicts extension capacitor connections with a planar busbar, according to one or more embodiments.
FIG. 16 depicts a system including an integrated two-level and three-level assembly, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to systems for an extension board for an inverter, and, more particularly, to systems for an extension board for a multi-level inverter for an electric vehicle. Inverters, such as those used to drive a motor in an electric vehicle, for example, are responsible for converting Direct Current (DC) into Alternating Current (AC) to drive the motor. A three phase inverter may include a bridge with six power device switches (for example, power transistors such as IGBT or MOSFET) that are controlled by Pulse Width Modulation (PWM) signals generated by a controller.

Two-level (2L) inverters dominate the traction inverter market due to cost and simple structure. However, a three-level (3L) inverter topology addresses issues with the 2L inverters, such as the harmonics in output voltage and relatively low efficiency at a higher switching frequency. In contrast to 2L inverters, multi-level (e.g., 3L) inverters can generate output voltage waveforms with lower harmonics to better resemble the sinusoidal references. Moreover, lower dv/dt and electromagnetic interference (EMI) emissions can be achieved using multi-level topology. A T-type topology 3L inverter may be a most suitable topology among the multi-level inverters due to three-level output voltage capability and lesser number of switching devices.

One or more embodiments may provide an additional PCB board to expand a 2L inverter to a 3L inverter, or a lower-level inverter to a higher-level inverter. By introducing the extension board into the system, one or more embodiments may provide an inverter with the capability of functioning in a 3L operation mode. One or more embodiments may provide an additional PCB with embedded switches, gate drivers, supplies, and capacitors. One or more embodiments may provide an additional PCB that is connectable to a 2L inverter using dedicated power leads and one or more board-to-board (B2B) connectors to the control PCB of the 2L inverter.

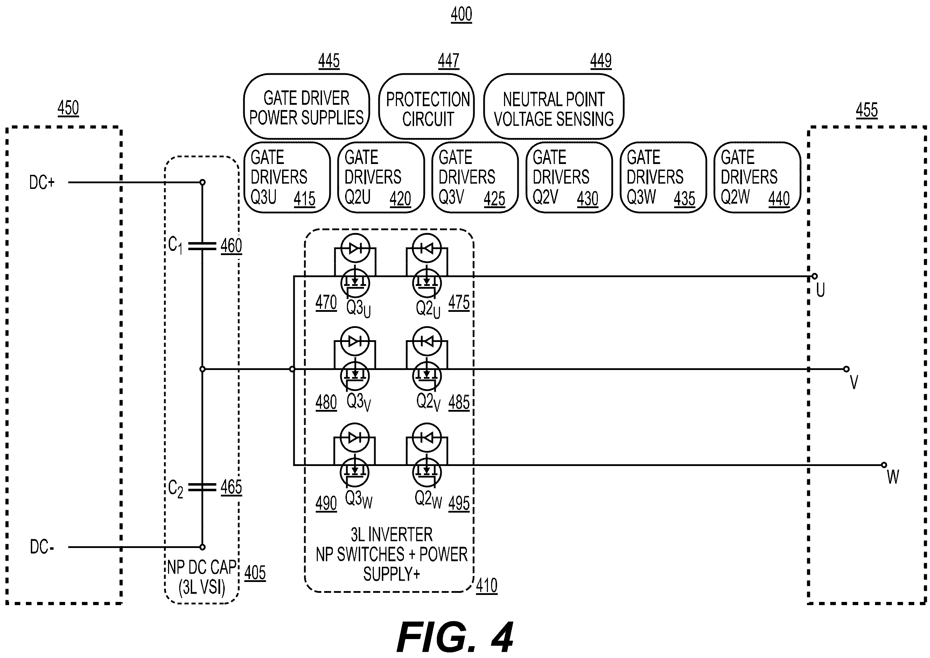

One or more embodiments may include an additional board including 3L electronics. 3L electronics may be represented by: neutral point (NP) DC CAP (3L VSI) (DC capacitor 3L voltage source inverter) (e.g., DC capacitor 405), the 3L inverter NP switches together with the gate driver (e.g., three-level inverter NP switches 410), and gate drivers power supplies (e.g., gate driver power supplies 445) and neutral point voltage sensor (e.g., neutral point voltage sensor 449) as shown in FIG. 4. One or more embodiments may provide an additional PCB board with current sensing, which may reduce the requirement of having an extra dedicated board for power sensing.

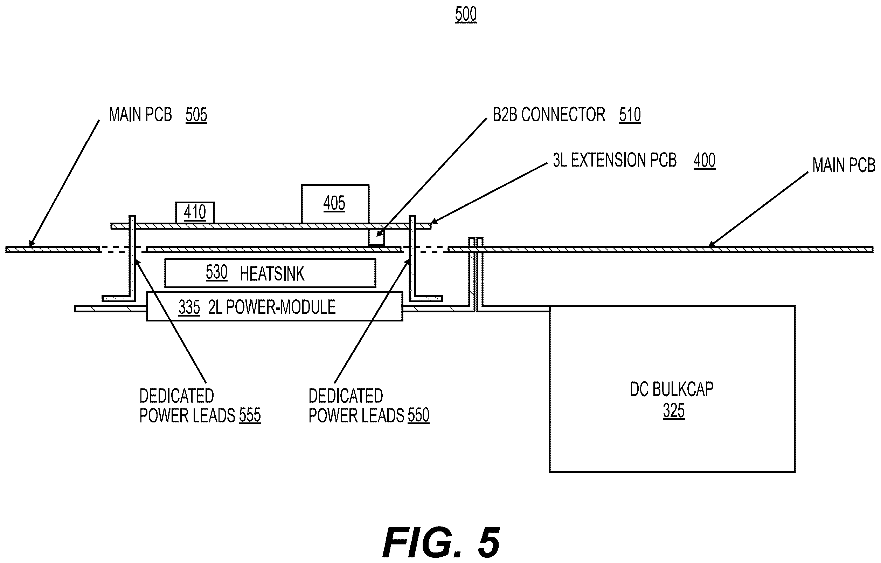

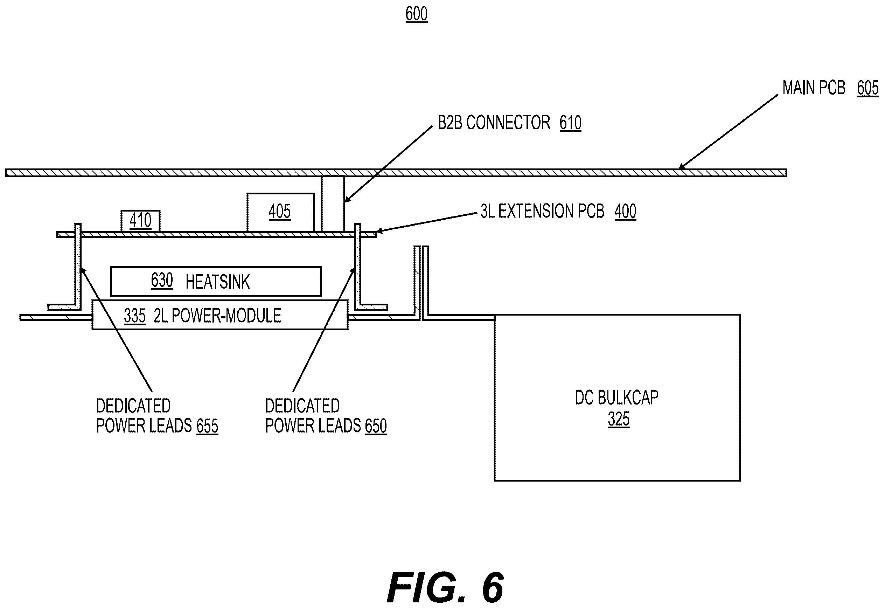

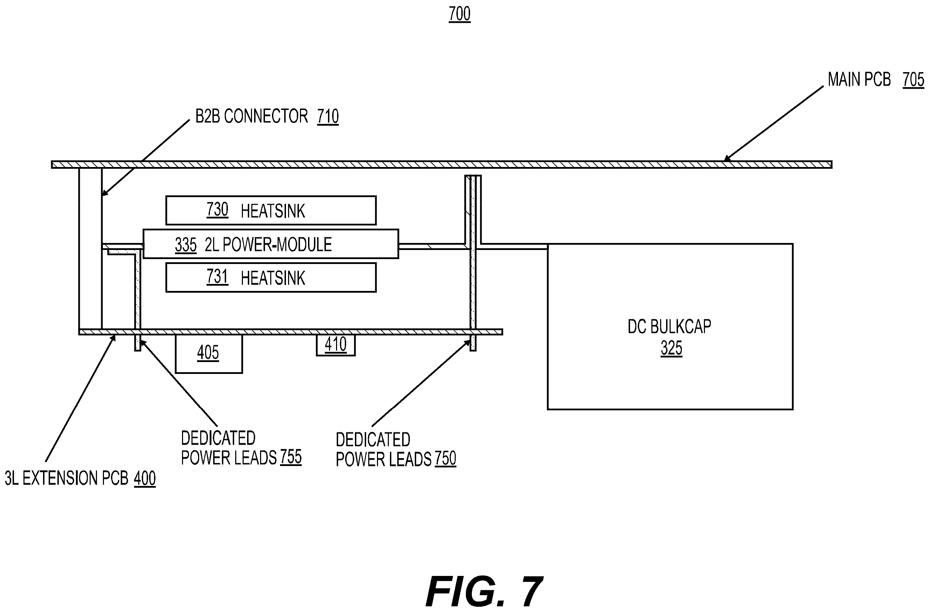

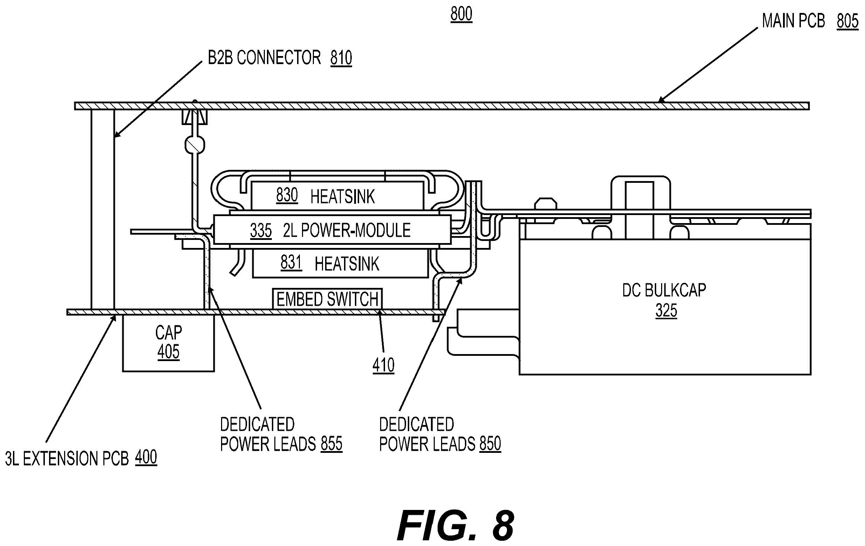

One or more embodiments may provide an extension board that adds a 3L functionality to an existing 2L inverter with an integrated plug and play preparation for the integration. The extension board may be added at the end or during the inverter assembly process. The plug and play preparation may be represented by the space availability in the housing and the dedicated electronics required for integration on the main PCB. This type of extension board may be integrated in a single side cooling system (see e.g., FIG. 5 and FIG. 6) or may be integrated in a dual side cooling system (see e.g., FIG. 7 and FIG. 8). Plug and play preparation may refer to the first board from a 2L inverter including an interface to allow an extension board connection. Plug and play preparation may refer to a main PCB or board including an interface with a board-to-board connector with control signals, supply, and monitoring sensing signals.

One or more embodiments may include a 3L inverter. One or more embodiments may provide an extension from a 2L to 3L inverter while re-using all 2L components and the basic 2L power cell design. One or more embodiments may be used as extension option of the 2L inverter. One or more embodiments may realize 2L operation with a very low power cell loop in combination with a low inductive and symmetric power cell for the T leg loops. The extension board may be flexible and scalable for different power, voltage levels, and capacitance values. The manufacturing process from the 2L inverter may be re-used. One or more embodiments may include an addition or adaptation of an extension power board that adds a 3 Level T-type VSI (voltage source inverter) topology and functionality to an existing 2L VSI.

One or more embodiments may include cooling of components of the extension board over a thermal path to the main heatsinks of the 2L VSI. One or more embodiments may include a multi-level inverter configured to convert DC power to AC power to drive a motor. The multi-level inverter may include a second printed circuit board (PCB) with one or more heat exchangers. The heat exchangers may include heat sinks or other components for cooling. Direct electrical connection of the PCB to the power leads of the 2L VSI with additional leads may be provided. All additional components to extend a 2L Inverter to a 3L T-Type inverter may be arranged on one additional PCB. Each phase leg may be realized with a separate PCB. 2L VSI with preparation for an extension board for a 3L inverter may be provided, which in one or more embodiments may include a control board with signal and supply interface for 3L operation, power lead design for additional connection of the extension board, and heatsink prepared for cooling of additional components.

One or more embodiments may provide a 3L (three-level) inverter and a 2L (two-level) inverter, and a 2L inverter which can be transformed into a 3L inverter by providing additional hardware. One or more embodiments may provide advantages and functions of both 2L inverters and 3L inverters and may provide reduced design and development time. One or more embodiments may provide an extension capacitor embedding a first and second capacitor (for example, C1 and C2 capacitors as shown in FIG. 4), along with planar busbar organization, which may provide capacitance and electrical connections to a 2L inverter hardware, and may extend it to operate as a 3L inverter.

Some designs may not provide the advantages described herein, and may lack the concept design, or further may require development or a long time to reach the market. One or more embodiments may provide shorter development time, and shorter time to reach the market. One or more embodiments may provide a system for use together with a 2L to 3L extension board (for example, as seen in FIG. 4). One or more embodiments may provide an extension board with 2L to 3L functionality.

One or more embodiments may provide a build configuration and integration of a first pair of capacitors including a first capacitor and a second capacitor. One or more embodiments may provide this external integration and as a result system integration and increase modularity of the system. One or more embodiments may provide an extension capacitor integrated in an existing 2L inverter together with a 3L extension board (for example, as seen in FIG. 4), which may facilitate a 3L operation.

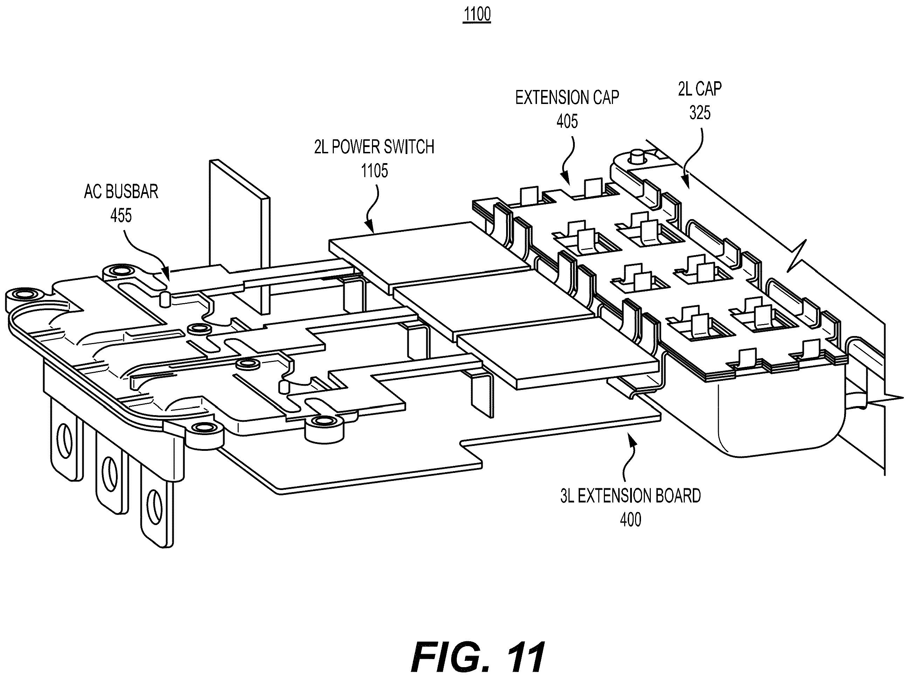

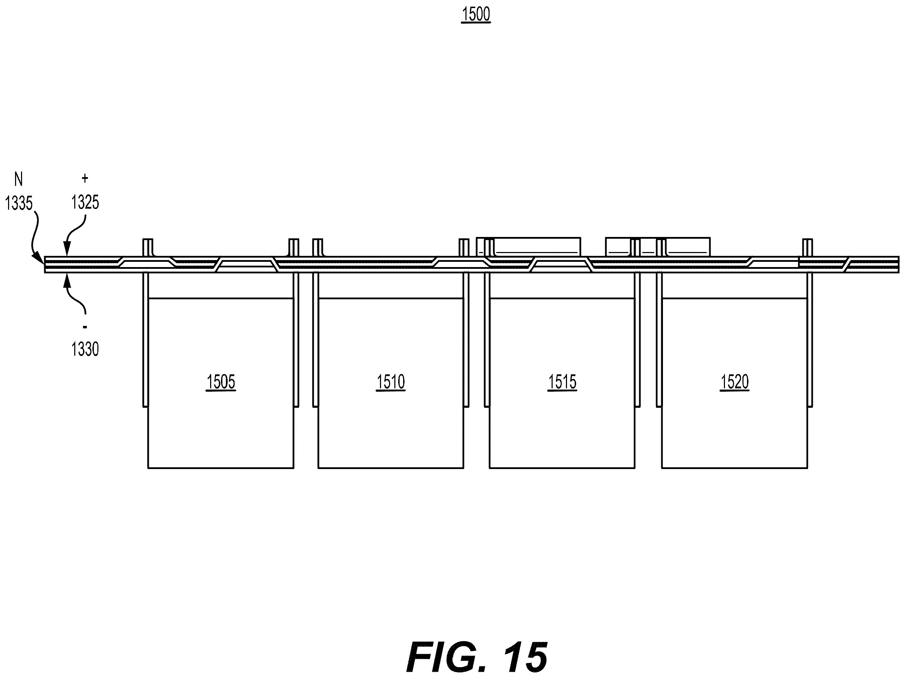

One or more embodiments may provide busbar arrangement for lower parasitic inductance and 3L functionality (for example, FIG. 11). One or more embodiments may provide bobbin arrangement for a planar busbar (for example, FIG. 15). One or more embodiments may provide an arrangement of bobbins connected to a combination of three or more planar busbars, (for example one positive busbar, one negative busbar, and one neutral busbar), in a single DC extension Bulk capacitor (for example, as shown in FIG. 15) to allow planar arrangement of busbar for a 3L functionality with reduced parasitic inductance. One or more embodiments may provide three planar busbars to allow connection to the 2L switches and 3L extension Board, containing the T-Leg switches, on one side and to the existing 2L capacitor on the other side. One or more embodiments may provide an extension capacitor which can be placed depending on the optimization of 2L or 3L operation.

One or more embodiments may provide a three planar busbar arrangement which may allow one or more bobbins to connect positive, negative, and neutral busbars facilitating a 3L functionality (for example, an example of bobbin configuration may be depicted in FIG. 15). One or more embodiments may provide busbars which may be designed with an input area with a positive (+) and negative (-) connection to an existing 2L capacitor and two output areas, one with a positive (+) and negative (-) connection to the 2L switch and one neutral point connection area that may connect to the extension board.

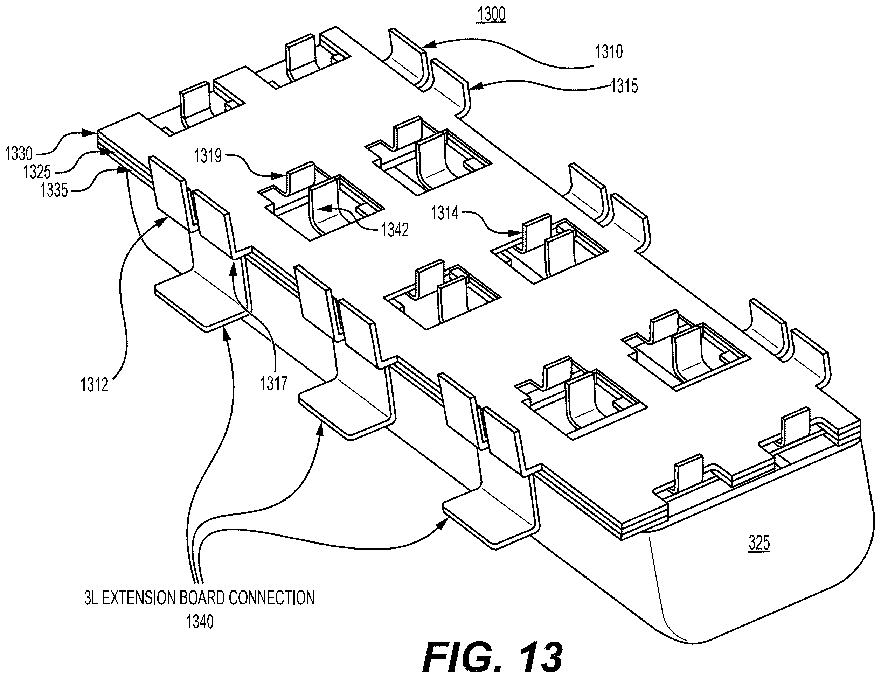

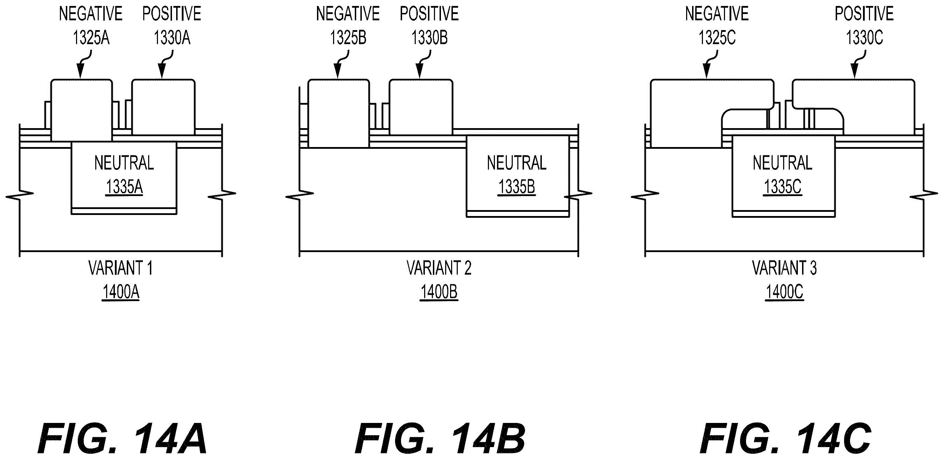

One or more embodiments may provide busbar interconnections design (for example, FIG. 13). One or more embodiments may provide leads, and input/output areas (for example, FIG. 13). One or more embodiments may provide a busbar interconnections design (for example, FIG. 14A, FIG. 14B, FIG.14C). One or more embodiments may provide a type of three planar busbar which may allow different designs of the connection depending on loop inductance and neutral point routing possibilities (for example, FIG. 14A, FIG. 14B, FIG.14C).

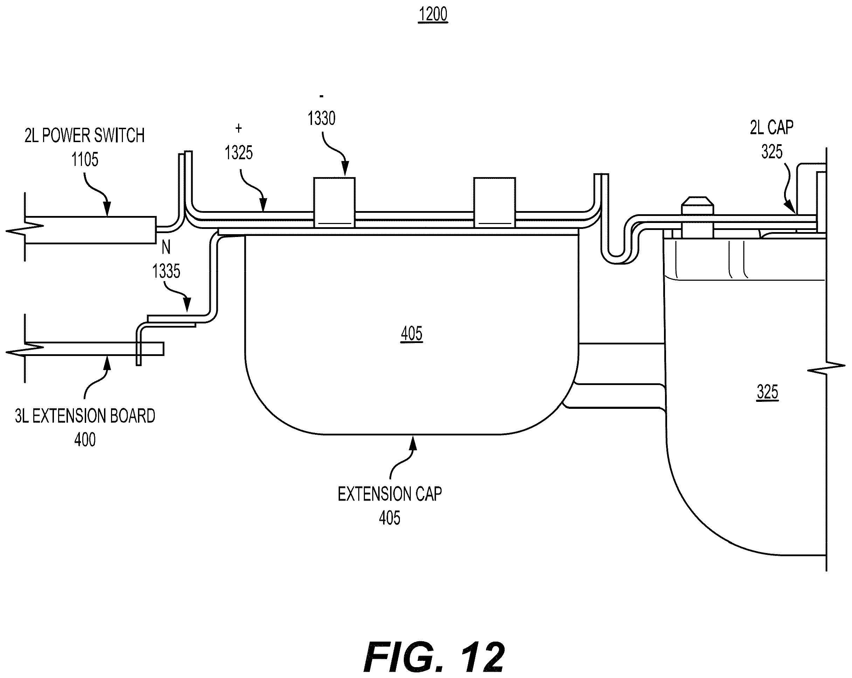

One or more embodiments may provide integration as a connection link (for example, FIG. 12). One or more embodiments may provide a capacitor integrated as an extension capacitor and acting as a link between the 2L capacitor, 2L switches, and 3L extension board (for example, FIG. 12), where the bobbins and busbar design may be arranged and designed in such way that combines with the existing 2L cap. One or more embodiments may provide 2L switch and extension board which may offer a full 3L functionality as well as a 2L functionality. One or more embodiments may provide bobbins which may have different configurations based on manufacturing constrains as well as the current path.

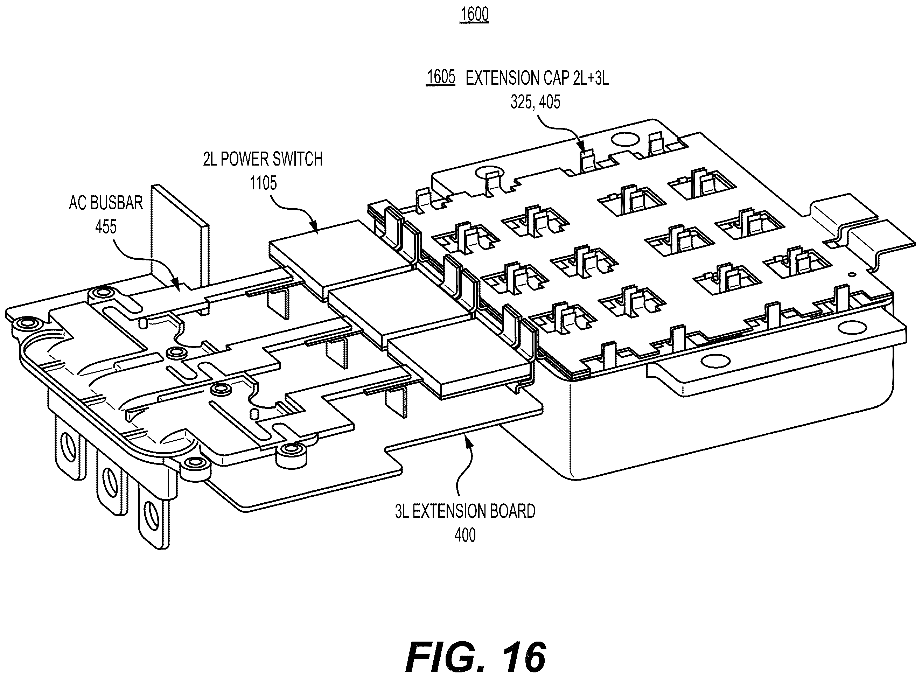

One or more embodiments may provide an integration as a combination in single capacitor (for example, FIG. 16). One or more embodiments may provide an integration solution (for example, a combination 2L and 3L capacitor covered by a busbar which may be depicted in FIG. 16). One or more embodiments may provide an integration which may be represented by combining the extension capacitor with the 2L capacitor (for example, as depicted in FIG. 11), into a single capacitor (for example, as depicted in FIG. 16).

One or more embodiments may provide a build configuration and integration of a first and second capacitor (for example, C1 and C2) as an external extension capacitor, replacing the integrated first and second capacitors (for example, integrated C1 and C2 capacitors) from the extension board. One or more embodiments may provide an external integration of the capacitors and system integration, and may increase modularity of the system. One or more embodiments may provide using an additional PCB board to realize expansion from a two-level inverter to a three-level inverter. One or more embodiments may provide introducing an extension board plus extension capacitor into the system, and may provide that the inverter may receive the capability of functioning in a three-level operation mode.

One or more embodiments may provide the extension capacitor may be added to the system when the environment does not allow integration of the cap on the extension PCB. One or more embodiments may provide the extension board and extension capacitor may build up together an extension kit for enabling 3L operation in a 2L inverter prepared for this extension. One or more embodiments may provide an ability to be added as an extension to one or more 2L to 3L extension boards (for example, three-level extension board 400).

One or more embodiments may provide a high voltage (HV) topology of a T-type three-level inverter (for example, inverter system 300). One or more embodiments may provide high voltage (HV) power components and circuit blocks on an extension board with integrated first and second capacitors (for example, three-level extension board 400).

One or more embodiments may provide one or more integration possibilities for an extension capacitor. One or more embodiments may provide a system representation with capacitor on extension board. One or more embodiments may provide a capacitor representation on extension board. One or more embodiments may provide an integration of the extension cap with existing 2L bulk capacitor. One or more embodiments may provide integration as a connection link.

One or more embodiments may provide additional integration possibilities for the extension capacitor. One or more embodiments may provide a busbar interconnections design. One or more embodiments may provide a bobbin arrangement for the planar busbar.

One or more embodiments may provide possibilities for the extension capacitor. One or more embodiments may provide integration as a combination in a single capacitor. One or more embodiments may provide a 2L capacitor and a 3L extension capacitor replaced by one single hybrid capacitor (for example, extension capacitor 1605).

One or more embodiments may provide a solution for converting a 2L inverter to 3L Inverter. One or more embodiments may provide an extension capacitor for a 2L inverter to operate as 3L inverter while reusing all two level components and the basic 2L power cell design (for example, power module and bulk capacitor). One or more embodiments may provide an extension option of the 2L inverter to 3L inverter. One or more embodiments may provide an extension capacitor which may be flexible and scalable for different power, voltage levels, and capacitance values. One or more embodiments may provide a manufacturing process wherein the manufacturing process from the 2L inverter may be re-used.

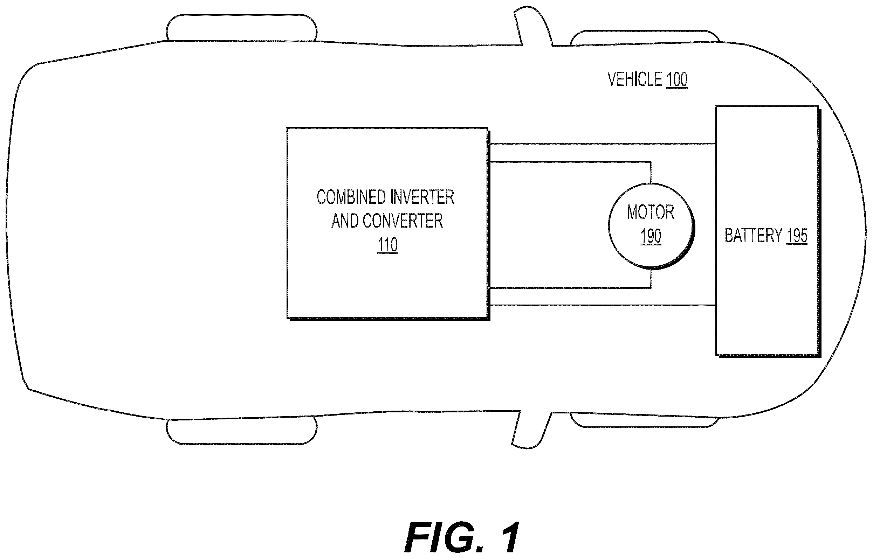

FIG. 1 depicts an exemplary system infrastructure for a vehicle including a combined inverter and converter, according to one or more embodiments. Alternatively, the inverter may be an inverter without a converter. In the context of this disclosure, the inverter without a converter, or the combined inverter and converter, may be referred to as an inverter. As shown in FIG. 1, electric vehicle 100 may include an inverter 110, a motor 190, and a battery 195. The inverter 110 may include components to receive electrical power from an external source and output electrical power to charge the battery 195 of electric vehicle 100. The inverter 110 may convert DC power from the battery 195 in electric vehicle 100 to AC power, to drive (e.g. rotate) the motor 190 of the electric vehicle 100, for example, but the embodiments are not limited thereto. The inverter 110 may be bidirectional, and may convert DC power to AC power, or convert AC power to DC power, such as during regenerative braking, for example. The inverter 110 may be a three-phase inverter, a single-phase inverter, or a multi-phase inverter.

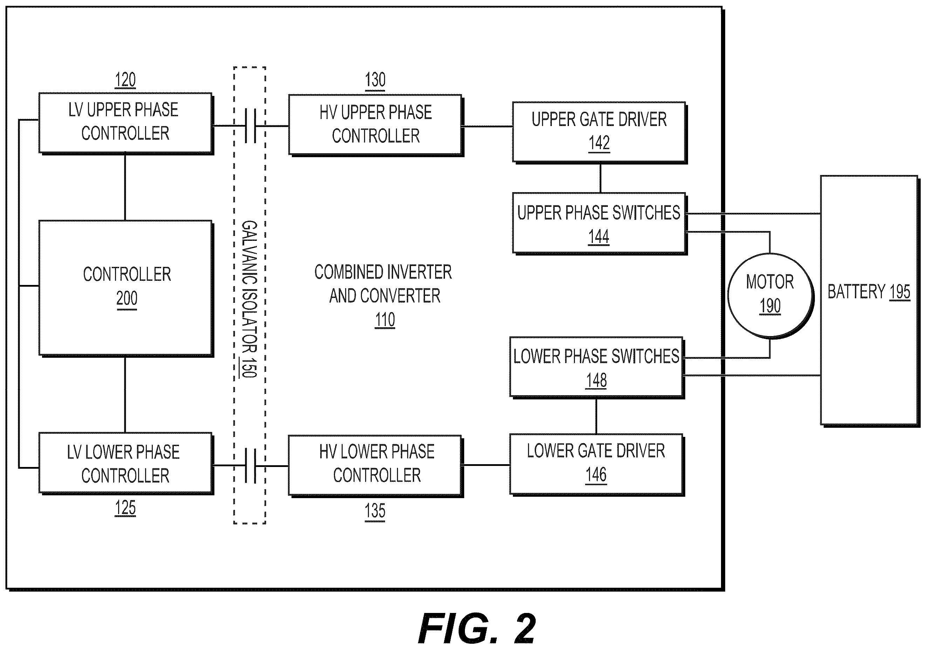

FIG. 2 depicts an exemplary system infrastructure for the combined inverter and converter of FIG. 1, according to one or more embodiments. Inverter 110 may include an inverter controller 200 to control the inverter 110. Inverter 110 may include a low voltage upper phase controller 120 separated from a high voltage upper phase controller 130 by a galvanic isolator 150. Inverter 110 may include a low voltage lower phase controller 125 separated from a high voltage lower phase controller 135 by galvanic isolator 150. Inverter 110 may include a high voltage upper phase controller 130 including a gate driver power supply, an upper gate driver 142, and upper phase switches 144. Inverter 110 may include a high voltage lower phase controller 135 including a gate drive power supply, a lower gate driver 146, and lower phase switches 148. Upper phase switches 144 and lower phase switches 148 may be connected to motor 190 and battery 195. Galvanic isolator 150 may be one or more of optical, transformer-based, or capacitance-based isolation, but embodiments are not limited thereto. Galvanic isolator 150 may be one or more capacitors with a value from approximately 20fF to approximately 100fF, with a breakdown voltage from approximately 6kV to approximately 12kV, for example, but embodiments are not limited thereto. Galvanic isolator 150 may include a pair of capacitors, where one capacitor of the pair carries an inverse data signal from the other capacitor of the pair to create a differential signal for common-mode noise rejection. Galvanic isolator 150 may include more than one capacitor in series. Galvanic isolator 150 may include one capacitor located on a first IC, or may include a first capacitor located on a first IC and a second capacitor located on a second IC that communicates with the first IC.

Inverter 110 may include a low voltage area, where voltages are generally less than 5V, for example, and a high voltage area, where voltages may exceed 500V, for example. The low voltage area may be separated from the high voltage area by galvanic isolator 150. Inverter controller 200 may be in the low voltage area of inverter 110, and may send signals to and receive signals from low voltage upper phase controller 120. Low voltage upper phase controller 120 may be in the low voltage area of inverter 110, and may send signals to and receive signals from high voltage upper phase controller 130. Low voltage upper phase controller 120 may send signals to and receive signals from low voltage lower phase controller 125. High voltage upper phase controller 130 may be in the high voltage area of inverter 110. Accordingly, signals between low voltage upper phase controller 120 and high voltage upper phase controller 130 pass through galvanic isolator 150. High voltage upper phase controller 130 may send signals to and receive signals from the upper gate driver 142. The upper gate driver 142 may send signals to and receive signals from the upper phase switches 144. Upper phase switches 144 may be connected to motor 190 and battery 195. Upper phase switches 144 and lower phase switches 148 may be used to transfer energy from motor 190 to battery 195, from battery 195 to motor 190, from an external source to battery 195, or from battery 195 to an external source, for example. The lower phase system of inverter 110 may be similar to the upper phase system as described above.

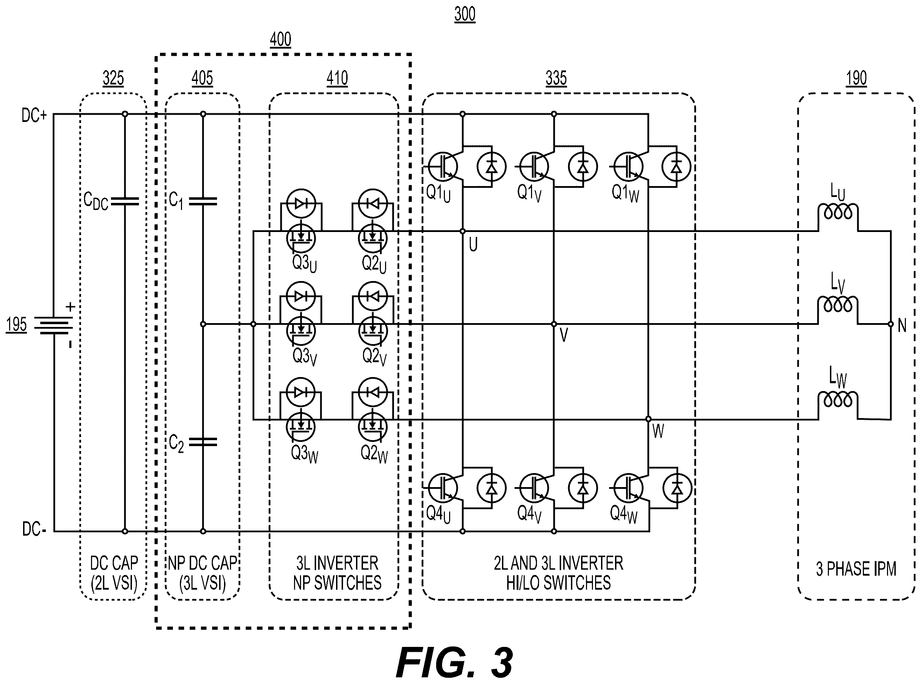

FIG. 3 depicts an exemplary electrical schematic of a T-Type three-level inverter, according to one or more embodiments. Inverter system 300, which may be a T-Type three-level inverter, may include motor 190, battery 195, DC bulk capacitor 325, three-level extension board 400, and two-level power module 335. Battery 195 may be connected to DC bulk capacitor 325. Three-level extension board 400 may include DC capacitor 405 and three-level inverter NP switches 410. Three-level extension board 400 may be electrically connected to two-level power module 335. Two-level power module 335 may be connected to motor 190. Two-level power module 335 may include components of inverter 110, such as galvanic isolator 150, high voltage upper phase controller 130, high voltage lower phase controller 135, upper gate driver 142, upper phase switches 144, lower gate driver 146, and lower phase switches 148, for example. However, the disclosure is not limited thereto.

FIG. 4 depicts a three-level extension printed circuit board, according to one or more embodiments. Three-level extension board 400 may include DC capacitor 405, three-level inverter NP switches 410, Q3u gate drivers 415, Q2u gate drivers 420, Q3v gate drivers 425, Q2v gate drivers 430, Q3w gate drivers 435, Q2w gate drivers 440, gate driver power supplies 445, DC power leads 450, and AC power leads 455. DC power leads 450 may be connected to DC capacitor 405. DC capacitor 405 may include DC capacitor 460 and DC capacitor 465. Three-level inverter NP switches 410 may connect to DC capacitor 405. Three-level inverter NP switches 410 may include Q3u switch 470, Q2u switch 475, Q3v switch 480, Q2v switch 485, Q3w switch 490, and Q2w switch 495. Three-level inverter NP switches 410 may connect to AC power leads 455. Three-level extension board 400 may include Q3u gate drivers 415, Q2u gate drivers 420, Q3v gate drivers 425, Q2v gate drivers 430, Q3w gate drivers 435, and Q2w gate drivers 440. Three-level extension board 400 may include gate driver power supplies 445, protection circuit 447, and neutral point voltage sensor 449. Three-level extension board 400 may be a second PCB electronically connected to a main PCB, which may be a first PCB.

FIG. 5 depicts a single side cooling system including an extension PCB located above a main PCB, according to one or more embodiments. Inverter 500 may include main PCB 505 first PCB, board-to-board connector 510, three-level extension board 400, second PCB, heatsink 530, two-level power module 335 power module, DC power leads 550, AC power leads 555, DC capacitor 405, and three-level inverter NP switches 410. Main PCB 505 may be a first PCB.

Inverter 500 may include three-level extension board 400 to expand a 2 Level inverter to a 3 Level inverter. By introducing the three-level extension board 400 into the system, the inverter may function in a 3 Level operation mode. As an example, three-level extension board 400 may include embedded switches such as three-level inverter NP switches 410, gate drivers, supplies, and capacitors that may be connected to a 2 Level inverter using the dedicated power leads (e.g., AC power leads 555 or DC power leads 550), and a board-to-board connector 510 to the control PCB of the 2 Level inverter, which may be main PCB 505.

FIG. 6 depicts a single side cooling system including an extension PCB located below a main PCB, according to one or more embodiments. Inverter 600 may include main PCB 605, board-to-board connector 610, three-level extension board 400, DC bulk capacitor 325, heatsink 630, two-level power module 335, DC power leads 650, AC power leads 655, DC capacitor 405, and three-level inverter NP switches 410.

FIG. 7 depicts a double side cooling system with an extension PCB including components on one side, according to one or more embodiments. Inverter 700 may include main PCB 705, board-to-board connector 710, three-level extension board 400, DC bulk capacitor 325, heatsink 730, heatsink 731, two-level power module 335, DC power leads 750, AC power leads 755, DC capacitor 405, and three-level inverter NP switches 410. Inverter 700 may depict two-level power module 335 between main PCB 705 and three-level extension board 400. Main PCB 705 and three-level extension board 400 may be connected by board-to-board connector 710. Heatsink 730 and heatsink 731 may be located on one or more sides of two-level power module 335. DC capacitor 405 and three-level inverter NP switches 410 may be on one side (i.e., the same side) of three-level extension board 400.

FIG. 8 depicts a double side cooling system with an extension PCB including components on two sides, according to one or more embodiments. Inverter 800 may include main PCB 805, board-to-board connector 810, three-level extension board 400, DC bulk capacitor 325, heatsink 830, heatsink 831, two-level power module 335, DC power leads 850, AC power leads 855, DC capacitor 405, and three-level inverter NP switches 410. DC capacitor 405 and three-level inverter NP switches 410 may be on two sides (i.e., opposite sides) of three-level extension board 400.

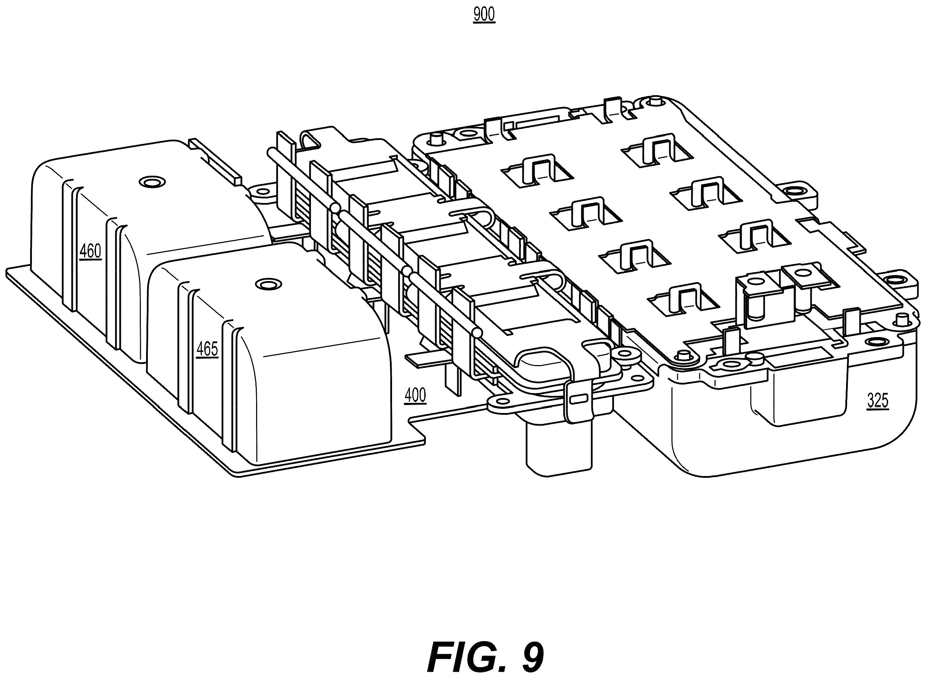

FIG. 9 depicts an exemplary system with capacitors on an extension board, according to one or more embodiments. As depicted in FIG. 9, system 900 may include DC bulk capacitor 325 and three-level extension board 400. Three-level extension board 400 may include DC capacitor 460 and DC capacitor 465. System 900 may include one or more busbars (e.g., busbars on DC bulk capacitor 325) for two-level functionality where one or more extension capacitors (for example, DC capacitor 405, DC capacitor 460, or DC capacitor 465) are on a second printed circuit board (for example, three-level extension board 400).

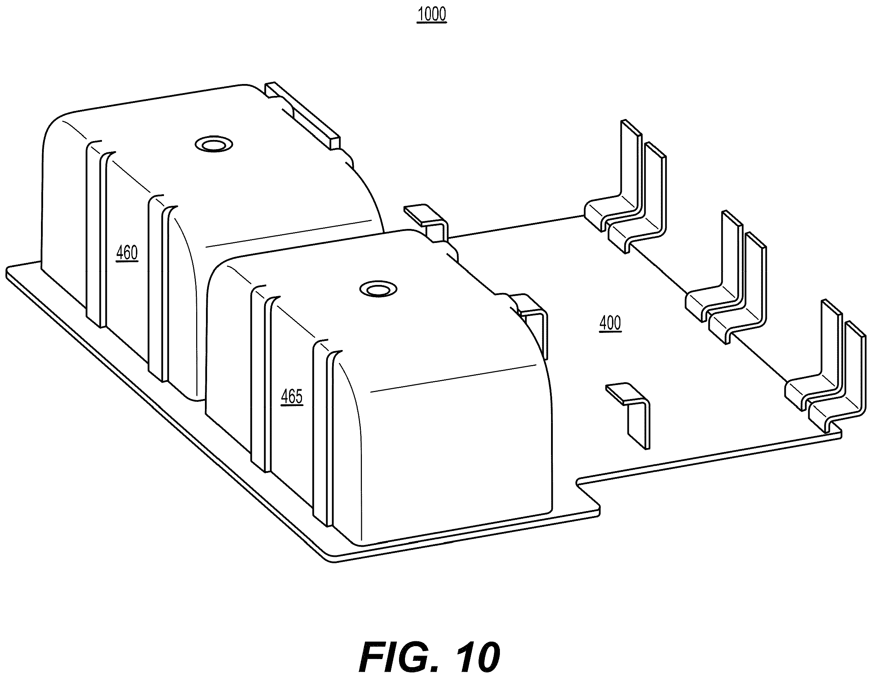

FIG. 10 depicts capacitors on an extension board, according to one or more embodiments. As depicted in FIG. 10, system 1000 may include three-level extension board 400. Three-level extension board 400 may include DC capacitor 460 and DC capacitor 465. System 1000 may include the one or more busbars (e.g., negative busbar 1325, positive busbar 1330, and neutral busbar 1335) in addition to one or more extension capacitors (for example, DC capacitor 460 and DC capacitor 465) are on a second printed circuit board (for example, three-level extension board 400).

FIG. 11 depicts a system including an extension assembly, according to one or more embodiments. As depicted in FIG. 11, system 1100 may include a DC bulk capacitor 325, a DC capacitor 405 (which may be an extension capacitor), a three-level extension board 400, 2L power switch 1105, and AC power leads 455 (which may be an AC busbar). DC bulk capacitor 325, DC capacitor 405, and three-level extension board 400 may be connected by one or more busbars, which may include one or more DC busbars (e.g., negative busbar 1325, positive busbar 1330, and neutral busbar 1335). Three-level extension board 400 may include connections to 2L power switch 1105.

System 1100 may include a multi-level inverter configured to convert DC power to AC power to drive a motor (for example, motor 190). System 1100 may include a battery (for example, battery 195) configured to supply DC power to a multi-level inverter 110, where the motor 190 is configured to receive AC power from the multi-level inverter 110 to drive the motor 190. System 1100 may include a multi-level inverter 110, battery 195, and motor 190 provided as a vehicle (for example, vehicle 100).

The multi-level inverter of system 1100 may include a first printed circuit board for a two-level inverter, a power module electrically connected to the first printed circuit board, one or more busbars (e.g., negative busbar 1325, positive busbar 1330, neutral busbar 1335, and/or busbars on DC bulk capacitor 325), one or more extension capacitors (e.g., DC capacitor 405, DC capacitor 460, and or DC capacitor 465) electrically connected to the one or more busbars, and a second printed circuit board (e.g., three-level extension board 400) electrically connected to the power module and to the first printed circuit board. The second printed circuit board (e.g., three-level extension board 400) may include one or more extension switches (e.g., three-level inverter NP switches 410) electrically connected to the one or more busbars (e.g., negative busbar 1325, positive busbar 1330, neutral busbar 1335), and may include one or more extension controllers to control the one or more extension switches.

System 1100 may include one or more two-level busbars (e.g., busbars on DC bulk capacitor 325) and one or more two-level capacitors (for example, DC bulk capacitor 325) electrically connected to the one or more two-level busbars. The one or more busbars may be three-level busbars (e.g., negative busbar 1325, positive busbar 1330, and/or neutral busbar 1335), may be on the one or more extension capacitors (e.g., DC capacitor 405, DC capacitor 460, DC capacitor 465), and/or may be connected to the one or more two-level busbars (e.g., busbars on DC bulk capacitor 325).

FIG. 12 depicts a connection of an extension assembly, according to one or more embodiments. As depicted in FIG. 12, system 1200 may include DC bulk capacitor 325, three-level extension board 400, DC capacitor 405, 2L power switch 1105, negative busbar 1325, positive busbar 1330, and neutral busbar 1335. System 1200 may include one or more busbars (e.g., negative busbar 1325, positive busbar 1330, neutral busbar 1335) between one or more two-level capacitors (e.g., DC bulk capacitor 325) and a power module (e.g., 2L power switch 1105). System 1200 may include one or more extension capacitors (e.g., DC capacitor 405, DC capacitor 460, DC capacitor 465) between the one or more two-level busbars (e.g., negative busbar 1325, positive busbar 1330, neutral busbar 1335) and a second printed circuit board (e.g., three-level extension board 400). System 1200 may include the second printed circuit board (e.g., three-level extension board 400) electrically connected to both the power module (e.g., 2L power switch 1105) and the first printed circuit board (e.g., 2L power switch 1105 and main PCB 505) through the one or more busbars (e.g., negative busbar 1325, positive busbar 1330, neutral busbar 1335).

FIG. 13 depicts an extension capacitor and busbar assembly, according to one or more embodiments. System 1300 may depict a design for busbar interconnections. System 1300 may include DC bulk capacitor 325, negative busbar 1325, positive busbar 1330, and neutral busbar 1335. Negative busbar 1325 may include first negative connector 1310, second negative connector 1312, and third negative connector 1314. First negative connector 1310 may connect to a negative side of DC bulk capacitor 325, second negative connector 1312 may connect to a negative side of a first phase of 2L power switch 1105, and third negative connector 1314 may connect to a negative side of DC capacitor 405. First negative connector 1310 may be on a first side of negative busbar 1325, second negative connector 1312 may be on a second side (opposite to the first side) of negative busbar 1325, and third negative connector 1314 may be in an interior area of negative busbar 1325.

Positive busbar 1330 may include first positive connector 1315, second positive connector 1317, and third positive connector 1319. First positive connector 1315 may connect to a positive side of DC bulk capacitor 325, second positive connector 1317 may connect to a positive side of a first phase of 2L power switch 1105, and third positive connector 1319 may connect to a positive side of DC capacitor 405. First positive connector 1315 may be on a first side of positive busbar 1330, second positive connector 1317 may be on a second side (opposite to the first side) of positive busbar 1330, and third positive connector 1319 may be in an interior area of positive busbar 1330.

Neutral busbar 1335 may include three-level extension board connectors 1340 and neutral connector 1342. Three-level extension board connectors 1340 may connect to three-level extension board 400, and neutral connector 1342 may connect to a neutral node of DC capacitor 405.. Three-level extension board connectors 1340 may be on a side of neutral busbar 1335 with second negative connector 1312 and second positive connector 1317, and neutral connector 1342 may be in an interior area of neutral busbar 1335.

Second positive connector 1317 and second negative connector 1312 may extend in a first direction, and three-level extension board connectors 1340 may extend in a second direction opposite to the first direction.

FIG. 14A depicts busbar connections in a first configuration, according to one or more embodiments. System 1400A may include a busbar assembly including negative busbar 1325 between positive busbar 1330 and neutral busbar 1335. System 1400A may include negative connector 1325A (e.g., second negative connector 1312), positive connector 1330A (e.g., second positive connector 1317), and neutral connector 1335A (e.g., one of three-level extension board connectors 1340). Negative connector 1325A may be extended in a first direction, positive connector 1330A may be extended in the first direction, and neutral connector 1335A may be extended in a second direction opposite to the first direction. Neutral connector 1335A may be positioned between positive connector 1330A and negative connector 1325A along a longitudinal axis of the busbars (e.g., negative busbar 1325, positive busbar 1330, and neutral busbar 1335).

FIG. 14B depicts busbar connections in a first configuration, according to one or more embodiments. System 1400B may include a busbar assembly including neutral busbar 1335 between negative busbar 1325 and positive busbar 1330. System 1400B may include negative connector 1325B, positive connector 1330B, and neutral connector 1335B. System 1400B may include negative connector 1325B extended in a first direction, positive connector 1330B extended in the first direction, and neutral connector 1335B extended in a second direction opposite to the first direction. Positive connector 1330B may be positioned between negative connector 1325B and neutral connector 1335B along a longitudinal axis of the busbars (e.g., negative busbar 1325, positive busbar 1330, and neutral busbar 1335).

FIG. 14C depicts busbar connections in a first configuration, according to one or more embodiments. System 1400C may include a busbar assembly including neutral busbar 1335 between negative busbar 1325 and positive busbar 1330. System 1400C may include negative connector 1325C, positive connector 1330C, and neutral connector 1335C. System 1400C may include negative connector 1325C extended in a first direction, positive connector 1330C extended in the first direction, and neutral connector 1335C extended in a second direction opposite to the first direction. Neutral connector 1335C may be positioned between positive connector 1330C and negative connector 1325C along a longitudinal axis of the busbars (e.g., negative busbar 1325, positive busbar 1330, and neutral busbar 1335). Negative connector 1325C and positive connector 1330C may have cut-out portions for voltage clearance from neutral connector 1335C.

FIG. 15 depicts extension capacitor connections with a planar busbar, according to one or more embodiments. System 1500 may include negative busbar 1325, positive busbar 1330, neutral busbar 1335, first capacitor 1505, second capacitor 1510, third capacitor 1515, and fourth capacitor 1520. Neutral busbar 1335 may be between negative busbar 1325 and positive busbar 1330. Negative busbar 1325 may be between neutral busbar 1335 and positive busbar 1330. Positive busbar 1330 may be between negative busbar 1325 and neutral busbar 1335. Negative busbar 1325, positive busbar 1330, and neutral busbar 1335 may be in a stacked arrangement.

FIG. 16 depicts a system including an integrated two-level and three-level assembly, according to one or more embodiments. System 1600 may include three-level extension board 400, AC power leads 455, 2L power switch 1105, and extension capacitor 1605. Extension capacitor 1605 may include DC bulk capacitor 325 (for example, for two-level functionality) and DC capacitor 405 (for example, for three-level functionality). Extension capacitor 1605 may include both two-level and three level functionality. System 1600 may include a busbar assembly. System 1600 may include a busbar assembly configured to cover one or more extension capacitors and one or more two-level capacitors (for example, extension capacitor 1605 may include DC bulk capacitor 325 and DC capacitor 405).

One or more embodiments may provide an additional PCB board to expand a 2L inverter to a 3L inverter. By introducing the extension board into the system, one or more embodiments may provide an inverter with the capability of functioning in a 3L operation mode. One or more embodiments may provide an additional PCB with embedded switches, gate drivers, supplies, and capacitors. One or more embodiments may provide an additional PCB that is connectable to a 2L inverter using dedicated power leads and one or more board-to-board (B2B) connectors to the control PCB of the 2L inverter. One or more embodiments may provide an additional PCB board with current sensing, which may reduce the requirement of having an extra dedicated board for power sensing.

One or more embodiments may provide an extension board that adds a 3L functionality to an existing 2L inverter with an integrated plug and play preparation for the integration. One or more embodiments may provide an extension from a 2L to 3L inverter while re-using all 2L components and the basic 2L power cell design. One or more embodiments may be used as extension option of the 2L inverter. One or more embodiments may realize 2L operation with a very low power cell loop in combination with a low inductive and symmetric power cell for the T leg loops. The extension board may be flexible and scalable for different power, voltage levels, and capacitance values. The manufacturing process from the 2L inverter may be re-used.

One or more embodiments may include an addition or adaptation of an extension power board that adds a 3 Level T-type VSI (voltage source inverter) topology and functionality to an existing 2L VSI. Direct electrical connection of the PCB to the power leads of the 2L VSI with additional leads may be provided. All additional components to extend a 2L Inverter to a 3L T-Type inverter may be arranged on one additional PCB.

One or more embodiments may provide one or more solutions for converting a 2L inverter to 3L Inverter. One or more embodiments may provide an extension capacitor for a 2L inverter to operate as 3L inverter while reusing all two level components and the basic 2L power cell design (for example, power module and bulk capacitor). One or more embodiments may provide an extension option of the 2L inverter to 3L inverter. One or more embodiments may provide an extension capacitor which may be flexible and scalable for different power, voltage levels, and capacitance values. One or more embodiments may provide a manufacturing process wherein the manufacturing process from the 2L inverter may be reused.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

## Claims

1. A system comprising a multi-level inverter configured to convert DC power to AC power to drive a motor, wherein the multi-level inverter includes:
a first printed circuit board for a two-level inverter;
a power module electrically connected to the first printed circuit board;
one or more busbars;
one or more extension capacitors electrically connected to the one or more busbars; and
a second printed circuit board electrically connected to the power module and to the first printed circuit board, wherein the second printed circuit board includes:
one or more extension switches electrically connected to the one or more busbars, and
one or more extension controllers to control the one or more extension switches.

2. The system of claim 1, wherein:
the one or more busbars are two-level busbars, and
the one or more extension capacitors are on the second printed circuit board.

3. The system of any one of claims 1 to 2, further comprising:
one or more two-level busbars; and
one or more two-level capacitors electrically connected to the one or more two-level busbars,
wherein the one or more busbars are three-level busbars, are on the one or more extension capacitors, and are connected to the one or more two-level busbars.

4. The system of claim 3, wherein the one or more busbars are between the one or more two-level capacitors and the power module; and/or wherein the one or more extension capacitors are between the one or more two-level busbars and the second printed circuit board.

5. The system of any one of claims 1 to 4, wherein the second printed circuit board is electrically connected to the power module through the one or more busbars and to the first printed circuit board through one or more board-to-board connectors.

6. The system of any one of claims 1 to 5, wherein the one or more busbars include:
a positive busbar;
a negative busbar; and
a neutral busbar;
and wherein, preferably,
the negative busbar is between the positive busbar and the neutral busbar, or the neutral busbar is between the positive busbar and the negative busbar.

7. The system of claim 6, wherein the positive busbar includes a first positive connector to two-level capacitors on a first side of the positive busbar, and a second positive connector to the power module on a second side of the positive busbar, wherein the first side of the positive busbar is opposite to the second side of the positive busbar; and
wherein the negative busbar includes a first negative connector to the two-level capacitors on a first side of the negative busbar, and a second negative connector to the power module on a second side of the negative busbar, wherein the first side of the negative busbar is opposite to the second side of the negative busbar.

8. The system of claim 6 or 7, wherein the neutral busbar includes a neutral connector to the second printed circuit board on a same side of the one or more extension capacitors as the power module.

9. The system of any one of claims 6 to 8, wherein the positive busbar includes a positive connector extending in a first direction, and the neutral busbar includes a neutral connector extending in a second direction opposite to the first direction;
and, preferably, wherein the negative busbar includes a negative connector extending in the first direction, and the neutral connector is between the positive connector and the negative connector along a longitudinal axis of the neutral busbar.

10. The system of any one of claims 1 to 9, further comprising:
a battery configured to supply the DC power to the multi-level inverter; and
the motor configured to receive the AC power from the multi-level inverter to drive the motor,
wherein the multi-level inverter, the battery, and the motor are provided as a vehicle.

11. A busbar assembly for a multi-level inverter; the busbar assembly comprising:
a positive busbar including a first positive connector to one or more extension capacitors, a second positive connector to one or more two-level capacitors, and a third positive connector to one or more power modules;
a negative busbar including a first negative connector to the one or more extension capacitors, a second negative connector to the one or more two-level capacitors, and a third negative connector to the one or more power modules; and
a neutral busbar including a first neutral connector to the one or more extension capacitors, and a second neutral connector to a multi-level extension board.

12. The busbar assembly of claim 11, wherein the positive busbar, the negative busbar, and the neutral busbar are in a stacked arrangement.

13. The busbar assembly of any one of claims 11 to 12, further comprising:
a two-level busbar assembly connectable to the busbar assembly,
wherein the second positive connector is connected to the one or more two-level capacitors through the two-level busbar assembly.

14. The busbar assembly any one of claims 11 to 13, wherein the busbar assembly is configured to cover the one or more extension capacitors and the one or more two-level capacitors.

15. An extension assembly for a multi-level inverter; the extension assembly comprising:
one or more extension capacitors;
a multi-level extension board including one or more extension switches;
a positive busbar including a first positive connector to the one or more extension capacitors, a second positive connector to one or more two-level capacitors, and a third positive connector to one or more power modules;
a negative busbar including a first negative connector to the one or more extension capacitors, a second negative connector to the one or more two-level capacitors, and a third negative connector to the one or more power modules; and
a neutral busbar including a first neutral connector to the one or more extension capacitors, and a second neutral connector to the multi-level extension board;
and, preferably, wherein the one or more two-level capacitors are connected to the one or more power modules through the positive busbar and the negative busbar.
